Europäisches Patentamt

European Patent Office

Office européen des brevets

(19)

(11) Numéro de publication: **0 189 706
B1**

(12) FASCICULE DE BREVET EUROPEEN

(45) Date de publication du fascicule du brevet:
14.06.89

(51) Int. Cl.⁴: **G 08 C 23/00**, G 01 D 5/36,
H 03 M 1/22

(21) Numéro de dépôt: **85402593.9**

(22) Date de dépôt: **20.12.85**

(54) Appareil optique de repérage de position.

(30) Priorité: **21.12.84 FR 8419711**

(43) Date de publication de la demande:
**06.08.86 Bulletin 86/32**

(45) Mention de la délivrance du brevet:
**14.06.89 Bulletin 89/24**

(84) Etats contractants désignés:
**AT BE CH DE GB IT LI LU NL SE**

(56) Documents cités:
**EP-A- 0 035 885
US-A- 4 117 460
US-A- 4 124 839**

**ELEKTRONIK, vol. 28, no. 26, décembre 1979, pages
60-62, Munich, DE; T.A. EPPES et al.: "Aufbau
fiberoptischer Zwischenverstärker mit niedriger
Leistungsaufnahme"**

(73) Titulaire: **M.C.B., 11, rue Pierre Lhomme,
F-92400 Courbevoie (FR)**

(72) Inventeur: **Taillebois, Jacques, Résidence
Brigitte 23, rue Ebisoires, F-78370 Plaisir (FR)**
Inventeur: **Renaud, Jean-Marie, 17, rue Pierre
Brossolette, F-92400 Courbevoie (FR)**
Inventeur: **Perrot, Jean-Claude, 8, Allée des Primevères,
F-95370 Montigny en Cormeilles (FR)**
Inventeur: **Gambs, Paul, 132, Chemin du Petit Bois,
F-69130 Ecully (FR)**

(74) Mandataire: **Lecca, Jean et al, CABINET
PLASSERAUD 84, rue d'Amsterdam, F-75009 Paris (FR)**

## Description

La présente invention concerne les appareils optiques de repérage par diascopie de la position d'un élément mobile.

On sait qu'un tel appareil comprend, d'une part, un disque ou une réglette comportant plusieurs pistes, chacune avec une succession de zones opaques et de zones transparentes fines alternantes et, d'autre part, un ensemble de lecture comportant, entre autres, une source de lumière et un ou plusieurs photodétecteurs qui détectent pour chaque piste si c'est une zone opaque ou une zone transparente qui est présente devant le ou les photodétecteurs; le disque ou la réglette, d'une part, et l'ensemble de lecture, d'autre part, sont mobiles l'un par rapport à l'autre soit en rotation (cas du disque), soit en translation (cas de la réglette). De plus au(x) photodétecteur(s) peut être associée une unité électronique de traitement des signaux émis par le(s) photodétecteur(s).

Généralement l'ensemble des moyens précisés se trouve disposé dans un volume réduit, ou bien, lorsque ces moyens sont éloignés les uns des autres, des conducteurs assurent les liaisons électriques, notamment entre les moyens d'alimentation en énergie, le système opto-électronique constituant ensemble de lecture et l'unité électronique de traitement des signaux.

Dans certaines applications il existe une distance non négligeable entre l'ensemble de lecture et l'unité électronique de traitement des signaux. Il y a lieu d'éviter toute liaison électrique entre ces deux ensembles du fait qu'une telle liaison risquerait d'être perturbée par des parasites, notamment en cas de transmission analogique des signaux entre l'ensemble de lecture et l'unité électronique de traitement des signaux.

La présente invention vise à permettre de réaliser un appareil optique de repérage par diascopie de la position d'un élément mobile éloigné de l'unité électronique de traitement des signaux qui représentent cette position, en évitant tout parasite.

Le brevet US-A-4 117 460 décrit un appareil de repérage de position en trois parties (un capteur de données qui coopère avec un élément porteur de code de position avec des pistes codées optiquement; un module opto-électronique avec une unité de traitement des signaux; et des moyens de transmission optique bi-directionnelle à fibres optiques), le module opto-électronique comprenant un émetteur de lumière et un lecteur dont les signaux sortants sont traités par l'unité de traitement, tandis que les moyens de transmission optique comportent au moins une première fibre optique pour transmettre la lumière émise par l'émetteur du module opto-électronique aux pistes codées optiquement et au moins une seconde fibre optique transmettant les signaux lumineux au lecteur opto-électronique du module.

Le dispositif selon le brevet US-A-4 117 460 ne réalise pas de multiplexage entre les réponses des différentes pistes codées dans le cas où l'élément porteur de code comporte plusieurs pistes codées, ce qui est indispensable pour une grande précision. Il faut donc un dispositif pour chaque piste codée.

Par ailleurs l'article d'Elektronik, volume 28, n° 26, décembre 1979, pages 60-62, Munich (RFA); T.A. Eppes et Al: «Aufbau fiberoptischer Zwischenverstärker mit niedriger Leistungsaufnahme» décrit un régénérateur avec conversion opto-électronique.

L'invention vise à réaliser un multiplexage entre les réponses des différentes pistes codées afin de réaliser un appareil très précis et compact.

Conformément à l'invention, on réalise un appareil de repérage de position, constitué en trois parties, à savoir:

– un capteur de données qui coopère avec un élément porteur de code de position comportant des pistes codées optiquement;

– un module opto-électronique avec une unité électronique de traitement des signaux; et

– des moyens de transmission optique bi-directionnelle à fibres optiques, et dans lequel:

– ledit capteur comprend, pour coopérer avec l'élément porteur de code de position comportant les pistes codées optiquement, un lecteur opto-électronique, disposé en regard des pistes codées pour recevoir la lumière ayant traversé les zones transparentes desdites pistes et transformant la lumière reçue en signaux électriques, un émetteur opto-électronique de lumière excité électriquement par ledit lecteur opto-électronique et une source d'alimentation autonome alimentant le lecteur opto-électronique et l'émetteur opto-électronique de ce capteur;

– le module comprend un émetteur opto-électronique de lumière et un lecteur opto-électronique, associé à l'unité de traitement pour les signaux électriques émis par ce lecteur opto-électronique en réponse à des signaux lumineux, l'alimentation de l'émetteur opto-électronique et du lecteur opto-électronique du module étant assurée par des moyens d'alimentation électrique; et

– lesdits moyens de transmission optique comportent au moins une première fibre optique pour transmettre la lumière émise par l'émetteur opto-électronique du module aux pistes codées optiquement de l'élément porteur de code, et au moins une seconde fibre optique transmettant les signaux lumineux émis par l'émetteur opto-électronique du capteur au lecteur opto-électronique du module;

appareil caractérisé en ce que le lecteur opto-électronique du capteur comprend plusieurs photodécteurs, à savoir au moins un photodécteur par piste codée de l'élément porteur de code, un circuit d'amplification et de mise en forme des impulsions électriques débitées par le ou les photodétecteurs correspondant à chaque piste en réponse à leur excitation lumineuse, et un registre à décalage à entrées parallèles, à savoir une entrée par piste codée, et à sortie unique série qui attaque l'émetteur opto-électronique du capteur.

Avantageusement:

– un système optique est disposé devant le lecteur opto-électronique du capteur et éventuellement devant le lecteur opto-électronique du module;

– un système optique est disposé entre chaque émetteur opto-électronique et la ou les fibres optiques transmettant la lumière émise par cet émetteur;

– la source d'alimentation autonome du capteur est constituée par une pile électrique, une cellule photovoltaïque alimentée en lumière extérieure par une fibre optique, ou une source d'alimentation locale par microgénération.

L'invention pourra, de toute façon, être bien comprise à l'aide du complément de description qui suit, ainsi que des dessins ci-annexés, lesquels complément et dessins sont, bien entendu, donnés surtout à titre d'indication.

La figure 1 illustre schémtiquement l'ensemble de l'appareil optique de repérage de position doté des perfectionnements selon l'invention, en montrant ses trois unités constitutives, à savoir le capteur, les moyens optiques de transmission et le module.

La figure 2 illustre les composants des trois unités illustrées sur la figure 1.

Selon l'invention et plus spécialement selon celui de ses modes d'application, ainsi que selon ceux des modes de réalisation de ses diverses parties, auxquels il semble qu'il y ait lieu d'accorder la préférence, se proposant, par exemple, de réaliser un appareil optique de repérage de position, on s'y prend comme suit ou d'une manière analogue.

L'invention est décrite ci-après dans un mode de réalisation préféré s'appliquant au repérage d'une position angulaire, l'organe mobile d'axe X–X portant solidaire de lui en rotation, un disque codé 1 avec plusieurs pistes codées concentriques, chacune avec une succession de très fines zones alternativement opaques et transparentes dans le sens périphérique.

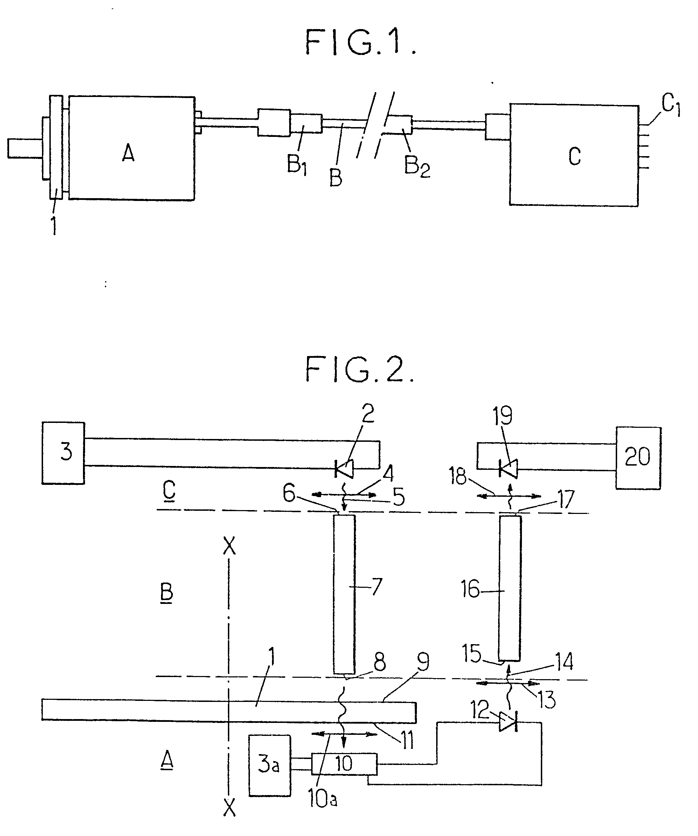

En se référant plus particulièrement à la figure 2, sur laquelle on a séparé par des traits interrompus le capteur A, le système à fibres optiques de transmission lumineuse B, constitué par exemple par un câble optique à deux ou plusieurs fibres, et le module opto-électronique C (ensembles A, B et C que l'on retrouve sur la figure 1), on voit que l'appareil selon l'invention comprend essentiellement:

– un premier émetteur opto-électronique de lumière 2, consituté par exemple par une diode électroluminescente et alimenté par des moyens d'alimentation 3, par exemple extérieurs et constitués par la source générale d'électricité qui est disponible;

– un système optique 4 formant, à partir de la lumière émise par l'émetteur de lumière 2, un faisceau de rayons 5 qui convergent sur la face d'entrée 6 d'une première fibre optique 7 dont la face de sortie 8 est disposée en regard d'une des surfaces 9 du disque codé 1, à savoir en face des pistes codées de ce disque;

– un premier lecteur opto-éléctronique 10 disposé en regard de l'autre surface 11 du disque codé 1, ce lecteur opto-électronique transformant la lumière, reçue depuis la face de sortie 8 de la première fibre optique 7, à travers une zone transparente du disque 11, et rendue convergente sur lui par un système optique 10a, en impulsions électriques qui atteignent un second émetteur opto-électronique 12 constitué par exemple (comme le premier émetteur) par une diode électroluminescente, le lecteur opto-électronique 10 et l'émetteur opto-électronique 12 du capteur A étant alimentés par une source autonome 3a constituée par exemple par une pile électrique, une cellule photovoltaïque alimentée en lumière extérieure par une fibre optique, ou une source d'alimentation locale par microgénération (cette dernière source pouvant être avantageusement formée par un système comportant un solénoïde qui entoure un barreau magnétique, des moyens – et en particulier une capsule manométrique – pour commander le déplacement relatif solénoïde/barreau magnétique dans le système, des moyens redresseurs dont l'entrée est connectée aux bornes du solénoïde, et des moyens de stockage d'énergie électrique connectés à la sortie desdits moyens redresseurs);

– un système optique 13, analogue au système optique 4 et qui transforme la lumière émise par la diode 12 en un faisceau de rayons 14 qui convergent sur la face d'entrée 15 d'une seconde fibre optique 16 dont la face de sortie est illustrée en 17;

– un système optique 18 qui focalise la lumière reçue de la face 17 de la fibre optique 16 sur un second lecteur opto-électronique 19 constitué par exemple par un photodédecteur, ce second lecteur 19 alimentant une unité de traitement 20.

On notera que le lecteur opto-électronique 10 comprend plusieurs photodétecteurs (au moins un par piste codée sur le disque 1), un circuit d'amplification et de mise en forme pour les sorties du ou des photodétecteurs associés à chaque piste, et un registre à décalage à entrées parallèles (à savoir une entrée pour chaque piste) et à sortie série, cette unique sortie étant connectée à la diode électroluminescente 12.

L'ensemble électronique du lecteur opto-électronique 10 est réalisé en une technologie qui permet au lecteur de consommer une énergie électrique réduite, notamment en une technologie du type CMOS.

Ce lecteur 10 débitera donc en définitive, pour chaque lecture, un groupe d'impulsions électriques et d'absences d'impuslion (en autant de positions qu'il y a de pistes codées), une impulsion électrique correspondant à une zone transparente et une absence d'impulsion à une zone opaque de la piste correspondant à la position en cause. Les lectures successives se manifestent donc par des groupes successifs d'impulsions et d'absences d'impulsion, les impulsions excitant la diode luminescente 12. Finalement le photodétecteur 19 envoie une succession de groupes d'impulsions et d'absences d'impulsion successifs (correspondant au groupe d'impulsions et d'absences d'impulsion émis par le lecteur 10) à l'unité de traitement 20.

Sur la figure 1 on a représenté:

– les unités du capteur A avec le disque codé 1, du câble optique B constituant les moyens de transmission à fibres optiques et du module C avec ses sorties $C_1$ vers les moyens d'utilisation des signaux de sortie du modole C; et

– les connecteurs $B_1$ et $B_2$ du câble optique B respectivement avec le capteur A et le module C.

Le fonctionnement de l'appareil comporte une première période de mise en service de l'ordre de 0,5 à 1 seconde, dans la cas d'une génération photovoltaïque de courant en 3a, mais qui peut être de durée différente pour un autre type de source d'énergie.

Cette période de mise en service est suivie par un premier cycle de travail comportant l'activation du premier émetteur opto-électronique 2 et du premier lecteur opto-électronique associé 10, puis, après verrouillage du code dans ce lecteur 10, la transmission série du code par activation du second émetteur et du second lecteur opto-électronique, 12 et 19 respectivement. Cette période de travail dure environ 50 µs.

On prévoit ensuite un temps de repos ou de recharge de la source d'énergie qui peut être de l'ordre de 10 à 20 ms, temps au bout duquel une nouvelle période de travail peut recommencer. Il en résulte donc que le cycle travail-repos peut recommencer par exemple tous les 20 ms environ.

On voit que les fibres optiques 7 et 16 et les systèmes opto-électroniques associés servent à la transmission à distance sans risques de parasites, d'une part, de la lumière émise par la diode 2 au disque 1 (fibre 7) et, d'autre part, des impulsions électriques émises par le lecteur 10 à l'unité de traitement 20 (fibre 16).

Comme il va de soi et comme il résulte d'ailleurs déjà de ce qui précède, l'invention ne se limite nullement à ceux de ses modes d'application et de réalisation qui ont été plus spécialement envisagés; l'étendue est définie par les revendications.

## Revendications

1. Appareil de repérage de position, constitué en trois parties, à savoir:

– un capteur de données (A) qui coopère avec un élément (1) porteur de code de position comportant des pistes codées optiquement;

– un module opto-électronique (C) avec une unité électronique de traitement des signaux (20); et

– des moyens (B) de transmission optique bidirectionnelle à fibres optiques, et dans lequel:

– ledit capteur (A) comprend, pour coopérer avec l'élément (1) porteur de code de position comportant les pistes codées optiquement, un lecteur opto-électronique (10), disposé en regard des pistes codées pour recevoir la lumière ayant traversé les zones transparentes desdites pistes et transformant la lumière reçue en signaux électriques, un émetteur opto-électronique de lumière (12) excité électriquement par ledit lecteur opto-électronique (10) et une source d'alimentation autonome (3a) alimentant le lecteur opto-électronique (10) et l'émetteur opto-électronique (12) de ce capteur;

– le module (C) comprend un émetteur opto-électronique de lumière (2) et un lecteur opto-électronique (19), associé à l'unité de traitement (20) pour les signaux électriques émis par ce lecteur opto-électronique (19) en réponse à des signaux lumineux, l'alimentation de l'émetteur opto-électronique (2) et du lecteur opto-électronique (19) du module étant assurée par des moyens d'alimentation électrique (3); et

– lesdits moyens de transmission optique (B) comportent au moins une première fibre optique (7) pour transmettre la lumière émise par l'émetteur opto-électronique (2) du module (C) aux pistes codées optiquement de l'élément (1) porteur de code, et au moins une seconde fibre optique (16) transmettant les signaux lumineux émis par l'émetteur opto-électronique (12) du capteur (A) au lecteur opto-électronique (19) du module (C);

appareil caractérisé en ce que le lecteur opto-électronique (10) du capteur comprend plusieurs photodétecteurs, à savoir au moins un photodétecteur par piste codée de l'élément (1) porteur de code, un circuit d'amplification et de mise en forme des impulsions électriques débitées par le ou les photodétecteurs correspondant à chaque piste en réponse à leur excitation lumineuse, et un registre à décalage à entrées parallèles, à savoir une entrée par piste codée, et à sortie unique série qui attaque l'émetteur opto-électronique (12) du capteur (A).

2. Appareil de repérage de position selon la revendication 1, caractérisé en ce qu'un système optique (10a, 18) est disposé devant le lecteur opto-électronique (10) du capteur (A) et éventuellement devant le lecteur opto-électronique (19) du module (C).

3. Appareil de repérage de position selon la revendication 1 ou 2, caractérisé en ce qu'un système optique (4, 13) est disposé entre chaque émetteur opto-électronique (2, 12) et la ou les fibres optiques (7, 16) transmettant la lumière émise par cet émetteur.

4. Appareil de repérage de position selon l'une quelconque des revendications précédentes, caractérisé en ce que l'ensemble électronique du lecteur opto-électronique (10) du capteur (A) est réalisé en une technologie qui permet au lecteur de consommer une énergie électrique réduite, notamment en une technologie du type CMOS.

5. Appareil de repérage de position selon l'une quelconque des revendications 1 à 4, caractérisé en ce que la source d'alimentation autonome (3a) du capteur (A) est constituée par une pile électrique.

6. Appareil de repérage de position selon l'une quelconque des revendications 1 à 4, caractérisé en ce que la source d'alimentation autonome (3a) du capteur (A) est constituée par une cellule photovoltaïque.

7. Appareil de repérage de position selon l'une quelconque des revendications 1 à 4, caractérisé en ce que la source d'alimentation autonome (3a) du capteur (A) est constituée par une source d'alimentation locale par microgénération, formée par un système comportant un solénoïde qui entoure un barreau magnétique, des moyens pour commander le déplacement relatif solénoïde/barreau magnétique dans le système, des moyens redresseurs dont l'entrée est connectée aux bornes du solénoïde, et des moyens de stockage d'énergie électrique connectés à la sortie desdits moyens redresseurs.

## Patentansprüche

1. Gerät zur Positionsbestimmung mit drei Teilen, einem Datensensor (A), der mit einem Positionscodeträgerelement (1) mit optisch kodierten Spuren zusammenwirkt, einem optisch-elektronischen Modul (C) mit einer elektronischen Einheit zur Signalbearbeitung (20) und in zwei Richtungen gerichteten Übertragungseinrichtungen (B) aus optischer Faser, wobei der Sensor (A) zum Zusammenwirken mit dem die optisch kodierten Spuren enthaltenen Positionscodeträgerelement (1) einen optisch-elektronischen Leser (10), der in Bezug auf die codierten Spuren zum Empfangen von Licht, das die transparenten Zonen der Spuren durchdrungen hat, angeordnet ist und das empfangene Licht in elektrische Signale umwandelt, einen optisch-elektronischen Lichtsender (12), der elektrisch durch den optisch-elektronischen Leser (10) angeregt wird, und eine eigenständige Versorgungsquelle (3a) aufweist, die den optisch-elektronischen Leser (10) und den optisch-elektronischen Sender (12) des Sensors versorgt, wobei das Modul (C) einen optisch-elektronischen Lichtsender (2) und einen optisch elektronischen Leser (19) aufweist, der mit der Bearbeitungseinheit (20) für die durch den optisch-elektronischen Leser (19) in Antwort auf die Lichtsignale ausgesendeten elektronischen Signale verbunden ist, wobei die Versorgung des optisch-elektronischen Senders (2) und des optisch elektronischen Lesers (19) des Moduls durch elektrische Versorgungseinrichtungen (3) gesichert ist, und wobei die optischen Übertragungseinrichtungen (B) wenigstens eine erste optische Faser (7) zum Übertragen des vom optisch-elektronischen Sender (2) des Moduls (C) ausgesendeten Lichts auf die optisch kodierten Spuren des Codeträgerelementes (1), und wenigstens eine zweite optische Faser (16) zum Übertragen der von dem optisch elektronischen Sender (12) des Sensors (A) ausgesendeten Lichtsignale auf den optisch elektronischen Leser (19) des Moduls (C) aufweisen, dadurch gekennzeichnet, dass der optisch elektronische Leser (10) des Sensors mehrere Fotodetektoren, von denen wenigstens ein Fotodetektor in der kodierten Spur des Codeträgerelementes (1) angeordnet ist, eine Verstärkungsschaltung zum Informsetzen von elektrischen Impulsen, die durch den oder die Fotodetektoren entsprechend jeder Spur in Antwort auf ihre Lichtanregung abgegeben werden, und ein Verstellregister mit parallelen Eingängen, von denen ein Eingang in der kodierten Spur liegt, und mit einer Reihe von Ausgängen aufweist, die auf den optisch-elektronischen Sender (12) des Sensors (A) einwirken.

2. Gerät zur Positionsbestimmung nach Anspruch 1, dadurch gekennzeichnet, dass ein optisches System (10a, 18) vor dem optisch-elektronischen Leser (10) des Sensors (A) und evtl. vor dem optisch-elektronischen Leser (19) des Moduls (C) angeordnet ist.

3. Gerät zur Positionsbestimmung nach Anspruch 1 oder 2, dadurch gekennzeichnet, dass ein optisches System (4, 13) zwischen jedem optisch-elektronischen Sender (2, 12) und der oder den das vom Sender ausgesendete Licht übertragenden optischen Fasern (7, 16) angeordnet ist.

4. Gerät zur Positionsbestimmung nach Anspruch 1 oder einem der folgenden, dadurch gekennzeichnet, dass die elektronische Anordnung des optisch-elektronischen Lesers (10) des Sensors (A) gemäss einer Technologie ausgebildet ist, die dem Leser einen geringen elektrischen Energieverbrauch ermöglicht, insbesondere einer Technologie des Typs CMOS.

5. Gerät zur Positionsbestimmung nach Anspruch 1 oder einem der folgenden, dadurch gekennzeichnet, dass die eigenständige Versorgungsquelle (3a) des Sensors (A) von einer elektrischen Batterie gebildet ist.

6. Gerät zur Positionsbestimmung nach einem der Ansprüche 1 bis 4, dadurch gekennzeichnet, dass die eigenständige Versorgungsquelle (3a) des Sensors (A) von einer fotoelektrischen Zelle gebildet ist.

7. Gerät zur Positionsbestimmung nach einem der Ansprüche 1 bis 4, dadurch gekennzeichnet, dass die eigenständige Versorgungsquelle (3a) des Sensors (A) von einer örtlichen Versorgungsquelle durch Mikrogeneration gebildet ist, welche aus einem System besteht, das einen einen Stabmagneten umgebenen Solenoiden, Einrichtungen zur Steuerung einer Relativbewegung zwischen Solenoid und Stabmagnet im System, Gleichrichtereinrichtungen, deren Eingänge mit Anschlussklemmen des Solenoiden verbunden sind, und Einrichtungen zur Speicherung elektrischer Energie aufweist, die mit den Ausgängen der Gleichrichtereinrichtungen verbunden sind.

## Claims

1. A position detector comprising three parts, namely:
   - a data pick-up (A) which co-operates with a position code carrier element (1) comprising optically coded tracks;
   - an opto-electronic module (C) with an electronic signal processing unit (20); and
   - optical-fibre bi-directional optical transmission means (B), and in which:
   - the said pick-up (A) comprises an opto-electronic reader (10) for co-operation with the position code carrier element (1) comprising the optically coded tracks, said opto-electronic reader (10) being disposed opposite the coded tracks to receive the light after it has passed through the transparent zones of said tracks and converting the received light into electrical signals, an opto-electronic light emitter (12) electrically energized by said opto-electronic reader (10) and an independent supply source (3a) supplying the opto-electronic reader (10) and the opto-electronic emitter (12) of said pick-up;

— the module (C) comprises an opto-electronic light emitter (2) and an opto-electronic reader (19) associated with the unit (20) for processing the electric signals emitted by said opto-electronic reader (19) in response to light signals, the opto-electronic emitter (2) and the opto-electronic reader (19) of the module being supplied by electric supply means (3); and

— the optical transmission means (B) comprise at least one first optical fibre (7) for transmitting the light emitted by the opto-electronic emitter (2) of the module (C) to the optically coded tracks of the code carrier element (1), and at least one second optical fibre (16) transmitting the light signals emitted by the opto-electronic emitter (12) of the pick-up (A) to the opto-electronic reader (19) of the module (C);

the detector being characterised in that the opto-electronic reader (10) of the pick-up comprises a plurality of photodetectors, i.e. at least one photodetector per coded track of the code carrier element (1), an amplification and shaping circuit for the electric pulses delivered by the or each photodetector corresponding to each track in response to their light energization, and a shift register having parallel inputs, namely one imput per coded track, and a single serial output which drives the opto-electronic emitter (12) of the pick-up (A).

2. A position detector according to claim 1, characterised in that an optical system (10a, 18) is disposed in front of the opto-electronic reader (10) of the pick-up (A) and, if required, in front of the opto-electronic reader (19) of the module (C).

3. A position detector according to claim 1 or 2, characterised in that an optical signal (4, 13) is disposed between each opto-electronic emitter (2, 12) and the or each optical fibre (7, 16) transmitting the light emitted by said emitter.

4. A position detector according to any of the preceding claims, characterised in that the electronic system of the opto-electronic reader (10) of the pick-up (A) is made with a technology allowing the reader to consume reduced electrical energy, more particularly a CMOS type technology.

5. A position detector according to any one of claims 1 to 4, characterised in that the self-contained supply source (3a) of the pick-up (A) is formed by an electric cell.

6. A position detector according to any one of claims 1 to 4, characterised in that the self-contained supply source (3a) of the pick-up (A) is formed by a photo-voltaic cell.

7. A position detector according to any one of claims 1 to 4, characterised in that the self-contained supply source (3a) of the pick-up (A) is formed by a local micro-generation supply source formed by a system comprising a solenoid surrounding a magnetic bar, means for controlling the relative solenoid/magnetic bar movement in the system, rectifier means whose input is connected to the terminals of the solenoid, and electrical energy storage means connected to the output of said rectifier means.

1/1

# FIG.1.

# FIG.2.